# EUROPÄISCHE PATENTSCHRIFT

(11) **EP 0 663 110 B1**
(45) Veröffentlichungstag und Bekanntmachung des Hinweises auf die Patenterteilung: **04.09.1996**
(21) Anmeldenummer: 93920657.9
(22) Anmeldetag: 23.09.1993
(51) Int. Cl.: H01S 3/19, H01L 33/00

(54) **HALBLEITERLASER MIT EINER ZWISCHEN ZWEI RESONATORSPIEGELN ANGEORDNETEN AKTIVEN SCHICHT UND VERFAHREN ZU SEINER HERSTELLUNG**
SEMICONDUCTOR LASER WITH AN ACTIVE FILM DISPOSED BETWEEN TWO RESONATOR MIRRORS, AND A METHOD FOR PRODUCING THE LASER
LASER A SEMI-CONDUCTEUR A COUCHE ACTIVE PLACEE ENTRE DEUX MIROIRS DE LA CAVITE, ET SON PROCEDE DE FABRICATION

(30) Priorität: 30.09.1992 DE 4232860
(43) Veröffentlichungstag der Anmeldung: 19.07.1995
(73) Patentinhaber: SIEMENS AKTIENGESELLSCHAFT, 80333 München (DE)
(72) Erfinder: HÖGER, Reiner,Dr., D-82140 Olching (DE); HEINECKE, Harald,Dr., D-89129 Langenau (DE)
(86) Internationale Anmeldenummer: DE9300906
(87) Internationale Veröffentlichungsnummer: WO9408369

(56) Entgegenhaltungen:
- EP-A- 0 433 051
- PATENT ABSTRACTS OF JAPAN vol. 14, no. 120 (E-899)6. März 1990 & JP,A,01 316 986 (HIKARI GIJUTSU KENKYU KAIHATSU KK)
- PATENT ABSTRACTS OF JAPAN vol. 11, no. 77 (E-487)7. März 1987 & JP,A,61 231 789 (MATSUSHITA ELECTRIC IND CO LTD)
- PATENT ABSTRACTS OF JAPAN vol. 12, no. 287 (E-643)5. August 1988 & JP,A,63 064 384 (HITACHI LTD)
- PATENT ABSTRACTS OF JAPAN vol. 14, no. 282 (E-942)19. Juni 1990 & JP,A,02 090 691 (NEC CORP)
- PATENT ABSTRACTS OF JAPAN vol. 14, no. 553 (E-1010)7. Dezember 1990 & JP,A,02 237 192 (AGANCY OF IND SCIENCE AND TECHNOLOGY)
- PATENT ABSTRACTS OF JAPAN vol. 12, no. 153 (E-607)11. Mai 1988 & JP,A,62 269 369 (MITSUBISHI CABLE IND LTD)

## Beschreibung

Die Erfindung betrifft einen Halbleiterlaser mit einer zwischen zwei Resonatorspiegeln angeordneten aktiven Schicht nach dem Oberbegriff des Anspruchs 1 und Verfahren zur Herstellung eines solchen Halbleiterlasers.

Ein Halbleiterlaser der genannten Art ist aus der JP-A-13 16986 bekannt. Bei diesem Laser ist die Schichtfläche, auf oder parallel zu der die aktive Schicht angeordnet ist, eine zur Oberfläche des Substrats senkrechte Umfangsfläche eines Kreiszylinders.

Aus der EP-A-0 433 051 ist ein Halbleiterlaser mit einer zwischen zwei Resonatorspiegeln angeordneten aktiven Schicht bekannt, bei dem die Resonatorspiegel senkrecht zur Oberfläche eines Substrats angeordnet sind und eine aktive Schicht auf oder parallel zu einer Schichtebene angeordnet ist, die senkrecht sowohl zur Oberfläche des Substrats als auch zu Spiegelebenen der Resonatorspiegel angeordnet ist.

Aus der JP-A-61 231 789 ist ein Halbleiterlaser bekannt, bei dem ebenfalls eine aktive Schicht auf oder parallel zu einer Schichtebene angeordnet ist, die senkrecht zu einer Oberfläche eines Substrats und damit parallel zur Oberflächenormalen dieser Oberfläche angeordnet ist.

Halbleiterlaserdioden können danach dadurch unterschieden werden, ob die Resonatorspiegel im wesentlichen parallel zur Oberfläche des den Laser tragenden Substrats angeordnet sind, oder ob die Resonatorspiegel mit der Oberfläche des Substrats einen von 0° wesentlich verschiedenen Winkel, beispielsweise 90° einschließen. Zur Erzielung einer effizienten Lasertätigkeit muß in beiden Fällen die laseraktive Schicht mit einem Material höherer Bandlücke und niedrigerer Brechzahl umschlossen sein, um eine Eingrenzung bzw. ein Confinement der Ladungsträger und des optischen Feldes zu erreichen.

Die beiden verschiedenen Laserarten benötigen derzeit zum Teil erheblich unterschiedliche Herstellungstechnologien. Im Falle der Halbleiterlaser mit Resonatorspiegeln, die mit der Oberfläche des Substrats einen von 0° wesentlich verschiedenen Winkel einschließen, kommen noch besondere Probleme für die Realisierung des elektrischen und optischen Confinements sowie durch die vergleichsweise hohen Bahnwiderstände hinzu.

Bei Halbleiterlasern mit Resonatorspiegeln, die mit der Oberfläche des Substrats einen von 0° wesentlich verschiedenen Winkel einschließen, gibt es für die Realisierung der Schichtstruktur mit der laseraktiven Schicht (Buried Heterostructure, BH-Struktur) in der Literatur viele Lösungsvorschläge, die sich im Grundsatz meist auf folgende Vorgehensweisen zurückführen lassen:
In einem ersten Epitaxieschritt wird auf einer Oberfläche eines Substrats eine Grundstruktur gewachsen, die aus einer Schicht aus einem Halbleitermaterial eines Leitfähigkeitstyps, beispielsweise einer n-leitenden Schicht, einer auf dieser Schicht aufgewachsenen laseraktiven Schicht und einer auf der laseraktiven Schicht aufgewachsenen Schicht des entgegengesetzten Leitungstyps, beispielsweise einer p-leitenden Schicht, besteht. Diese Grundstruktur wird in einem nachfolgenden Ätzschritt modifiziert und in einem zweiten Epitaxieschritt überwachsen. Bei dieser Vorgehensweise wird die Weite der laseraktiven Schicht durch die Ätzmaske bestimmt, außerdem zeigen solcherart durch Ätzen entstandene Halbleiterlaser sehr oft eine geringe Lebensdauer.

Während bei den Halbleiterlasern, bei denen die Resonatorspiegel mit der Oberfläche des Substrats und der Schichtebene der laseraktiven Schicht einen von 0° wesentlich verschiedenen Winkel einschließen, Resonatorspiegel ausreichen, die durch Spalten der Laserdiode entstehen, benötigt die andere Art Halbleiterlaser, bei denen die Resonatorspiegel im wesentlichen parallel zur Oberfläche des Substrats angeordnet sind, Spiegel mit Reflexionsgraden, die höher als 99% sind. Spiegel mit solch hohen Reflektivitäten werden in der Regel mit Hilfe von dielektrischen λ/4-Vielfachschichten realisiert, wobei λ die Wellenlänge des Laserlichts ist. Eine mögliche Schichtstruktur besteht aus einer auf der Oberfläche des Substrats aufgebrachten dielektrischen Vielfachschicht als ein Resonatorspiegel, der über diesem Resonatorspiegel in einem die Resonatorhöhe definierenden Abstand angeordneten Schichtstruktur aus der zwischen zwei Schichten angeordneten und zur Oberfläche des Substrats im wesentlichen parallelen laseraktiven Schicht, und aus einer den anderen Resonatorspiegel bildenden weiteren dielektrischen Vielfachschicht, die ebenfalls in einem die Resonatorhöhe definierenden Abstand von der Schichtstruktur angeordnet ist. Eine dielektrische Vielfachschicht ist typischerweise 3 bis 4 µm dick, die Resonatorhöhe beträgt 0,5 bis 1 µm. Die Wachstumsdauern betragen mehrere Stunden und sind um so höher, je langwelliger das Laserlicht ist. Für das Confinement der Ladungsträger oder des optischen Feldes gibt es im wesentlichen drei Varianten. Bei der ersten Variante (bekannt aus R.S. Geels, S.W. Corzine, J.W. Scott, D.B. Young und L.A. Coldren: Low Threshold Planarized Vertical-Cavity Surface-Emitting Lasers, IEEE Photonics Technology Letters, Vol. 2, S. 234-236 (1990) werden Säulen in den Abmessungen (typische Fläche 10x10µm², typische Höhe etwa 5 bis 8 µm) des Lasers geätzt. Die freigeätzten Bereiche werden meist zum Zwecke der Passivierung mit anderen Materialien aufgefüllt, optimal ist, im Sinne des BH-Prinzips, eine epitaktische Überwachsung. Diese Säulen sind zum einen sehr instabil und eine Kontaktierung ist nur sehr schwer möglich. Außerdem ist die Wellenführung problematisch und die Lebensdauer des Bauelelements ist auch bei einer epitaktischen Überwachsung sehr eingeschränkt. Die zweite Strukturvariante (ein aus Y.J. Young, T.G. Dziura, R. Fernandez, S.C. Wang, G. Du and S. Wang:Low-Threshold operation of a GaAs single quantum well mushroom structure surface-emitting laser, Appl. Phys. Lett.- 58, 1780-1782 (1991) bekannter Pilzlaser) ist der ersten prinzipiell ähnlich und weist daher auch deren prinzipiellen Nachteile auf. Technologisch interessanter ist die aus K.Tai, R. J. Fischer, K.W. Wang, S.N.G. Chu and A.Y. Cho: Use of implant isolation for fabrication of vertical cavitiy surface-emitting laser diodes, Electron. Lett. 25, 1644-1645 (1989) bekannte dritte Variante. Bei diesem Verfahren wird das elektrische Confinement dadurch erzielt, daß Bereiche, die nicht Lasergebiete sind, mit Hilfe einer Protonenimplantation semiisolierend gemacht werden. Nachteile dieser Methode sind die hohen Strahlenschäden und mangelnde optische Wellenführung.

Allen drei Verfahren gemeinsam ist der Nachteil, daß die Stromzuführung jeweils über die Spiegelpakete in Form von dielektrischen Vielfachschichten erfolgt. Diese Spiegelpakete weisen einen hohen Bahnwiderstand auf, der durch Dotieren nicht beliebig eingestellt werden kann.

Der Erfindung liegt die Aufgabe zugrunde, eine Vereinheitlichung der Herstellungstechnologie für beide Laserstrukturen, eine einfache Herstellung der Schichtstruktur bei Halbleiterlasern, bei denen die Resonatorspiegel im wesentlichen parallel zur Oberfläche des Substrats sind und eine Lösung des Problems der hohen Bahnwiderstände bei den zuletzt genannten Halbleiterlasern zu ermöglichen.

Der im Anspruch 1 angegebene Halbleiterlaser hat die Laserstruktur, bei welcher die Resonatorspiegel im wesentlichen parallel zur Oberfläche des Substrats angeordnet sind und läßt sich vorteilhaft mit dem in Anspruch 5 angegebenen Verfahren herstellen. Ein Halbleiterlaser mit der Laserstruktur, bei welcher die Resonatorspiegel mit der Oberfläche des Substrats einen von 0° wesentlich verschiedenen Winkel einschließen, läßt sich vorteilhaft mit dem im Anspruch 7 angegebenen Verfahren herstellen, das im wesentlichen das gleiche Verfahren wie das Verfahren nach Anspruch 5 ist und lediglich der anderen Laserstruktur Rechnung trägt.

Bevorzugte und vorteilhafte Ausgestaltungen des Halbleiterlasers nach Anspruch 1 gehen aus den Ansprüchen 2 bis 4 hervor.

Eine bevorzugte Ausgestaltung des Verfahrens nach Anspruch 5 ist im Anspruch 6 angegeben.

Eine bevorzugte Ausgestaltung des Verfahrens nach Anspruch 7 ist im Anspruch 8 angegeben.

Die Erfindung wird anhand der Figuren in der nachfolgenden Beschreibung beispielhaft näher erläutert.

Es zeigen
- Figuren 1 bis 5: im Querschnitt verschiedene Verfahrensstufen bei der Herstellung eines erfindungsgemäßen Halbleiterlasers,
- Figur 6: im Querschnitt eines nach dem Verfahren nach den Figuren 1 bis 5 hergestellten fertigen Halbleiterlasers, bei welchem die Resonatorspiegel parallel zur Oberfläche des Substrats angeordnet sind, und
- Figur 7: im Querschnitt einen fertigen Halbleiterlaser, bei dem die Resonatorspiegel senkrecht zur Oberfläche des Substrats angeordnet sind.

Bei dem beispielhaften Verfahren wird auf eine plane Oberfläche 20 eines Substrats 2 aus beispielsweise n-dotiertem InP ein Resonatorspiegel 11 aufgebracht, der beispielsweise aus einem Schichtpaket aus mehreren dielektrischen Vielfachschichten mit abwechselnd niedrigerer und höherer Brechzahl besteht. Diese Schichten sind vorzugsweise Epitaxieschichten, die mittels eines Molekularstrahl-Epitaxieverfahrens erzeugt werden. Der auf diese Weise aufgebrachte Resonatorspiegel 11 weist eine zur Oberfläche 20 des Substrats 2 parallele Oberfläche 111 auf.

Auf diese Oberfläche 111 des Resonatorspiegels 11 wird eine abdeckende Maske 5 aus einem ein epitaktisches Wachstum hemmenden Material, beispielsweise einem Oxid, aufgebracht, die zumindest einen, im dargestellten Beispiel mehrere Bereiche 115 der Oberfläche 111 des Resonatorspiegels 11 freiläßt. Jeder dieser Bereiche 115 grenzt auf einer Seite an einen Rand 51 und auf der anderen Seite an einen Rand 52 der Maske 5.

Auf der mit dieser Maske 5 abgedeckten Oberfläche 111 des Resonatorspiegels 11 wird ein Material mit einer im Vergleich zu dem für die aktive Schicht 15 vorgesehenen Material größeren Bandlücke und kleineren Brechzahl, beispielsweise n-dotiertes InP abgeschieden. Dieses Material scheidet sich nur in den Bereichen 115 und nicht auf der Maske 5 ab, so daß nur in den Bereichen 115 jeweils eine Schicht 13 aus dem Material mit der im Vergleich zu dem für die spätere aktive Schicht vorgesehenen Material größeren Bandlücke und kleineren Brechzahl entsteht.

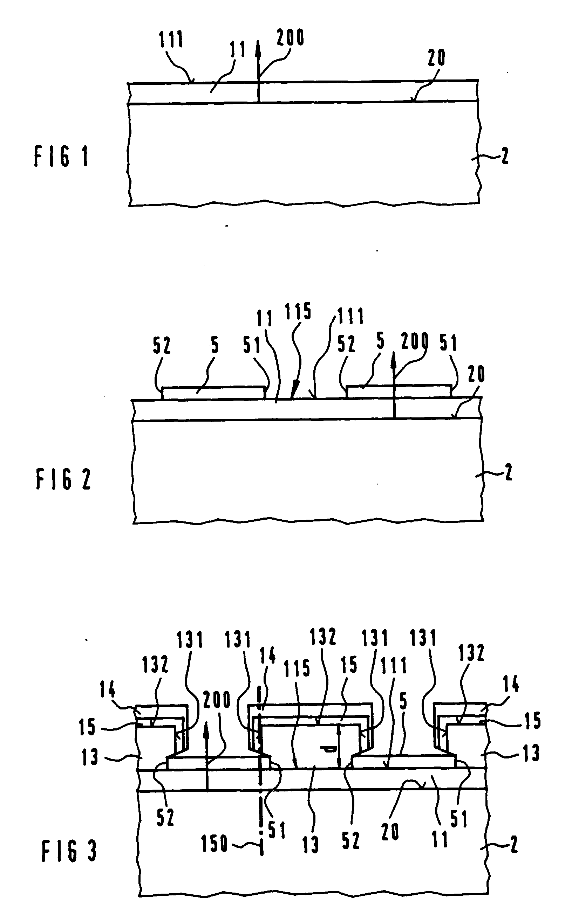

Bei der Abscheidung der Schichten 13 werden die Prozeßparameter überdies so gewählt, daß die Besonderheit vorliegt, daß längs der den freien Bereich 115 begrenzenden Ränder 51 und 52 der Maske jeweils ein Oberflächenabschnitt 131 entsteht, der mit der Oberflächennormalen 200 der Oberfläche 20 des Substrats 2 einen von 90° verschiedenen Winkel einschließt. Zwischen diesen Oberflächenabschnitten 131 weist jede Schicht 13 einen zur Oberfläche 20 des Substrats 2 parallelen Oberflächenabschnitt 132 auf. Beispielsweise verlaufen die Ränder 51 und 52 senkrecht zur Zeichenebene der Figuren 2 und 3. Entsprechend verlaufen die Oberflächenabschnitte 131 jeder Schicht 13 senkrecht zu dieser Zeichenebene. In dieser Zeichenebene schließen diese Oberflächenabschnitte 131 mit der Oberflächennormalen 200 einen beliebigen Winkel ein, der von 90° verschieden, beispielsweise 0° ist.

Diese Oberflächenabschnitte 131 definieren jeweils eine Schichtebene 150 für die spätere aktive Schicht 15.

Die Form der Maske 5 richtet sich nach den späteren Anwendungsfällen. Beispielsweise wird die Maske 5 so gewählt, daß die in den freien Bereichen 115 entstehenden Schichten 13 ein zweidimensionales Array aus Inseln zur Realisierung eines entsprechenden zweidimensionalen Arrays aus senkrecht zur Oberfläche 20 des Substrats 2, d.h in Richtung der Oberflächennormalen 200, abstrahlenden Halbleiterlasern 1 bilden.

Die Dicke d der Schichten 13 richtet sich nach der später gewünschten Resonatorgeometrie.

Auf die derart mit einer oder mehreren Schichten 13 strukturierte Oberfläche 111 des Resonatorspiegels 11 wird epitaktisch mittels eines metallorganischen epitaktischen Abscheideverfahrens das Material für die aktive Schicht 15 abgeschieden, das nur auf den Schichten 13, nicht aber auf dem Material der Maske 5 aufwächst. Es entsteht dadurch auf jeder Schicht 13 eine laseraktive Schicht 15, welche die Oberflächenabschnitte 131 und den dazwischenliegenden Oberflächenabschnitt 132 der aktiven Schicht 15 bedeckt.

Auf der in dieser Weise strukturierten Oberfläche 111 des Resonatorspiegels 11 wird mittels eines metallorganischen epitaktischen Abscheideverfahrens Material mit einer im Vergleich zu dem für die aktive Schicht 15 vorgesehenen Material größeren Bandlücke und kleineren Brechzahl für Schichten 14, beispielsweise p-dotiertes InP, aufgewachsen, das sich nur auf den aktiven Schichten 15, nicht aber auf dem Material der Maske 5 abscheidet. Nach diesem Verfahrensschritt ist die in Figur 3 gezeigte Struktur entstanden.

Durch selektives Abätzen der Maske 5 könnten aus dieser Struktur durch Brechen des Substrats oder Chips derart, daß zur Zeichenebene der Figur 3 parallele Bruchflächen entstehen, Halbleiterlaser erzeugt werden, die parallel zur Oberfläche 20 des Substrats 2 und senkrecht zur Zeichenebene abstrahlen, wobei die Bruchflächen die Resonatorspiegel definieren.

Auch könnten durch Aufbringen einer weiteren p-dotierten Schicht und Aufbringen eines zweiten Resonatorspiegels 12 auf diese Schicht, der parallel zur Oberfläche 20 des Substrats 2 ist, ein oder mehrere Halbleiterlaser 1 erzeugt werden, die vertikal zur Oberfläche 20 des Substrats 2 abstrahlen.

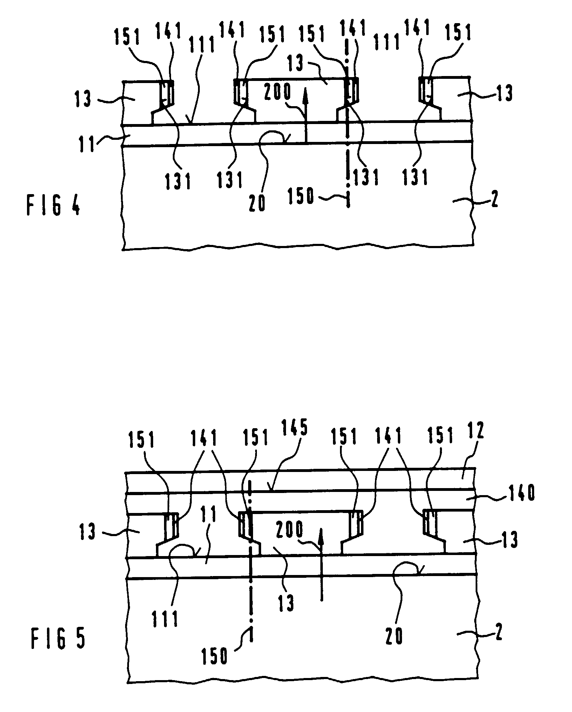

Zweckmäßigerweise wird aber so vorgegangen, daß die auf der aktiven Schicht 15 befindliche Schicht 14 und die aktive Schicht 15 durch ein Abtragverfahren, beispielsweise durch Ätzen, so weit reduziert werden, daß nur Schichtabschnitte 151 bzw. 141 dieser beiden Schichten 15 und 14 stehenbleiben, die auf dem mit der Oberfläche 20 des Substrats 2 den von 90° verschiedenen Winkel einschließenden Oberflächenabschnitt 131 der Schicht 13 aufgewachsen sind. Dabei wird vorzugsweise ein Abtragverfahren gewählt, das gleichzeitig die Maske 5 entfernt. Nach diesem Verfahrensschritt ist die Struktur nach Figur 4 entstanden.

Auf diese Struktur wird mittels eines metallorganischen epitaktischen Abscheideverfahrens eine weitere Schicht 140 aus einem Material aufgewachsen, das im wesentlichen gleich dem Material der Schicht 14 ist. Diese Schicht 140 wird in einer solchen Dicke aufgewachsen, daß sie die von der Maske 5 befreite Oberfläche 111 des Resonatorspiegels 11 und die reduzierten Schichtstrukturen mit jeweils den Schichten 13, 14 und 15 vollständig abdeckt.

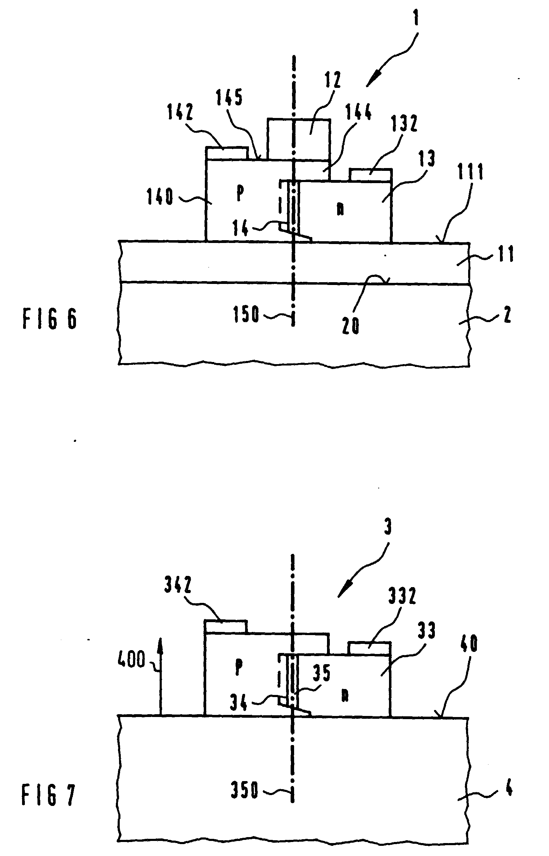

Auf die Oberfläche 145 dieser Schicht 140 wird der zweite Resonatorspiegel 12 aufgebracht, der den gleichen Aufbau wie der Resonatorspiegel 11 hat und auf die gleiche Weise hergestellt werden kann. Nach diesem Verfahrensschritt ist die in Figur 5 gezeigte Struktur entstanden.

Anstelle des obengenannten Abtragverfahrens können die nicht benötigten Schichtabteile auch beispielsweise durch Disordering in ihren Eigenschaften verändert werden.

Zur Herstellung eines funktionsfähigen Halbleiterlasers mit Abstrahlrichtung senkrecht zur Oberfläche 20 des Substrats 2 aus der Struktur nach Figur 5 wird der zweite Resonatorspiegel 12 teilweise abgetragen, so daß auf einer Seite der Schichtebene 150, in der die verbliebene aktive Schicht 15 angeordnet ist, ein Bereich der weiteren Schicht 140 und auf der anderen Seite dieser Schichtebene 150 ein Bereich der Schicht 13 freigelegt und auf die freigelegten Bereiche dieser Schichten 140 und 13 elektrische Kontakte 142 bzw. 132 aufgebracht. Es entsteht danach der in Figur 6 dargestellte Halbleiterlaser 1 mit Abstrahlrichtung senkrecht zur Oberfläche 20 des Substrats 2, der die zwischen den zwei Resonatorspiegeln 11 und 12 angeordnete Schichtstruktur aus der zwischen den zwei Schichten 13 und 14 in der bestimmten Schichtebene 150 angeordneten aktiven Schicht 15 auf der Oberfläche 20 des Substrats aufweist. Die Resonatorspiegel 11 und 12 sind parallel zur Oberfläche 20 des Substrats 2 angeordnet. Die beiden Schichten 13 und 14 bestehen jeweils aus einem Material mit einer im Vergleich zum Material der aktiven Schicht 15 größeren Bandlücke und kleineren Brechzahl und grenzen an die aktive Schicht 15 an. Die Schicht 140 kann zur Schicht 14 hinzugerechnet werden. Wesentlich ist, daß die Schichtebene 150, in der die aktive Schicht 15 angeordnet ist, mit der Oberflächennormalen 200 der Oberfläche 20 des Substrats 2 den von 90° verschiedenen Winkel, vorzugsweise 0°, einschließt.

Der eine Resonatorspiegel 11 ist auf der Oberfläche 20 des Substrats 2 aufgebracht. Auf der von dieser Oberfläche 20 abgekehrten Oberfläche 111 dieses Resonatorspiegels 11 sind nebeneinander die beiden Schichten 13 und 14 einschließlich der Schicht 140 mit der dazwischenliegenden aktiven Schicht 15 aufgebracht. Auf der von der Oberfläche 20 des Substrats 2 abgekehrten Seite der beiden Schichten 13 und 14 weist die Schicht 14, zu der die Schicht 141 zu zählen ist, einen die aktive Schicht 15 und zumindest einen Teil der einen Schicht 13 überdeckenden Schichtabschnitt 144 auf. Auf diesem überdeckenden Schichtabschnitt 144 ist der andere Resonatorspiegel 12 aufgebracht. Auf beiden Schichten 13 und 14 sind seitlich des anderen Resonatorspiegels 12 die elektrischen Kontakte 132 und 142 vorgesehen.

Der Halbleiterlaser 3 nach Figur 7 ist ein Halbleiterlaser, der parallel zur Oberfläche des Substrats abstrahlt. Dieser Halbleiterlaser 3 weist die zwischen zwei Resonatorspiegeln angeordnete Schichtstruktur aus der zwischen den beiden Schichten 33 und 34 angeordneten aktiven Schicht 35 auf der Oberfläche 40 des Substrats 4 auf. Die beiden Resonatorspiegel sind in zwei Spiegelebenen angeordnet, die senkrecht zur Oberfläche 40 des Substrats 4 und parallel zur Zeichenebene der Figur 7 in einem zu dieser Zeichenebene senkrechten Abstand voneinander angeordnet. Die beiden Schichten 33 und 34 bestehen jeweils aus einem Material mit einer im Vergleich zu einem Material der aktiven Schicht 35 größeren Bandlücke und kleineren Brechzahl und grenzen an die aktive Schicht 35 an. Beispielsweise besteht die Schicht 33 aus n-dotiertem InP und die Schicht 34 aus p-dotiertem InP. Wesentlich ist, daß die aktive Schicht 35 zumindest einen Schichtabschnitt aufweist, der in einer mit der Oberflächennormalen 400 der Oberfläche 40 des Substrats 4 einen von 90° verschiedenen Winkel einschließenden Schichtebene 350 angeordnet ist, wobei diese Schichtebene 350 mit der Spiegelebene jedes Resonatorspiegels 31 einen von 0° wesentlich verschiedenen Winkel einschließt. Beispielsweise steht die Schichtebene 350 senkrecht auf der Oberfläche 40 des Substrats 4 und senkrecht zur Zeichenebene der Figur 7. Im Beispiel nach Figur 7 ist nicht nur ein Schichtabschnitt, sondern die ganze aktive Schicht 35 der Schichtebene 350 angeordnet. Die Resonatorspiegel sind durch Bruchflächen des Substrats definiert. Elektrische Kontakte sind mit 332 und 342 bezeichnet.

Der Halbleiterlaser nach Figur 7 kann ähnlich wie der Halbleiterlaser nach Figur 6 aus einer Struktur hergestellt werden, die der Struktur nach Figur 5 ähnelt, aber keine Resonatorspiegel 11 und 12 aufweist.

Im Gegensatz zur sonst üblichen Technik werden bei den Halbleiterlasern 1 und 3 nach den Figuren 6 und 7 die elektrischen Ströme seitlich herangeführt. Dies hat folgende Vorteile:
a) die Kontaktierung erfolgt von oben, daraus folgt, daß die Struktur auch auf semiisolierendem Substrat aufgewachsen werden kann. Der Laser kann in einer Strukturform, bei der die Laserstrahlung vertikal zur Oberfläche des Substrats emittiert wird, noch auf dem Wafer getestet werden. Dies erlaubt ein "Full Wafer Processing", eine produktionstechnisch sehr wünschenswerte Möglichkeit.
b) Bei Halbleiterlasern, die senkrecht zur Oberfläche des Substrats abstrahlen, muß der obere Resonatorspiegel nicht epitaktisch aufgewachsen werden, da dieser nicht für den Stromtransport benötigt wird. Daher kann der obere Resonatorspiegel aus isolierendem Material aufgedampft werden, was sehr viel billiger als Epitaxie ist. Ebenso ist ein Metallspiegel möglich, oder eine Kombination von beiden. Wird eine Upside-Down-Montage gewählt, können die Materialien nach ihrer Wärmeleitfähigkeit ausgesucht werden.
c) In jedem Falle sind die Genauigkeitsanforderungen an die Epitaxie weniger stringent.

Weitere Vorteile der Struktur sind:
d) Werden der obere und untere Resonatorspiegel weggelassen und der Chip in der üblichen Lasergeometrie gebrochen, entsteht automatisch ein konventioneller BH-Laser mit epitaktisch definierter aktiver Zone, der parallel zur Oberfläche des Substrats emittiert.
e) Bei der Verwendung als senkrecht zur Oberfläche des Substrats emittierender Laser mit Quantum-Well-Strukturen als aktive Zone entfällt der hohe Genauigkeitsanspruch an die Epitaxie, da auf jeden Fall genügend aktives Material im Bereich der elektrischen Feldamplitude vorliegt. Es entfällt die Notwendigkeit einer epitaktisch komplizierten resonanten Struktur.

Das vorstehend beschriebene Herstellungsprinzip kann auf die Struktur des tunable Twin Guide Lasers (TTG-Laser) angewandt werden. Bei dem Herstellungsverfahren wird die Weite und Dicke der aktiven Schicht vorteilhafterweise durch die Epitaxie bestimmt und die Einwirkung eines Ätzprozesses wird verringert.

## Patentansprüche

1. Halbleiterlaser (1) mit einer auf einer Oberfläche (20) eines Substrats (2) zwischen zwei Resonatorspiegeln (11, 12) angeordneten Schichtstruktur, bei der auf oder parallel zu einer Schichtfläche (150) zwischen einer Schicht (13) aus einem Halbleitermaterial eines Leitfähigkeitstyps und einer Schicht (14) aus einem Halbleitermaterial eines zum einen Leitfähigkeitstyp entgegengesetzten Leitfähigkeitstyps eine an die beiden Schichten (13, 14) aus Halbleitermaterial angrenzende aktive Schicht (15) angeordnet ist,
- wobei die aktive Schicht (15) aus einem Material mit einer im Vergleich zum Halbleitermaterial sowohl des einen als auch des entgegengesetzten Leitfähigkeitstyps kleineren Bandlücke und größeren Brechzahl besteht,
- wobei die Resonatorspiegel (11, 12) parallel zur Oberfläche (20) des Substrats (2) angeordnet sind,
wobei ein Resonatorspiegel (11) auf der Oberfläche (20) des Substrats (2) angeordnet ist,
wobei auf der von der Oberfläche (20) des Substrats (2) abgekehrten Oberfläche (111) des auf der Oberfläche (20) des Substrats (2) angeordneten Resonatorspiegels (11) nebeneinander die Schicht (13) aus Halbleitermaterial eines Leitfähigkeitstyps die aktive Schicht (15) und die Schicht (14) aus Halbleitermaterial des zum einen Leitfähigkeitstyp entgegengesetzten Leitfähigkeitstyps angeordnet sind,
**dadurch gekennzeichnet,**
daß die Schichtfläche (150), auf oder parallel zu der die aktive Schicht (15) angeordnet ist, eine Schichtebene ist, und
daß diese Schichtfläche (150) mit der Oberflächennormalen (200) der Oberfläche (20) des Substrats (1) einen von 90° verschiedenen Winkel einschließt.

2. Halbleiterlaser nach Anspruch 1,
**dadurch gekennzeichnet,**
daß die Schichtebene (150), auf oder parallel zu der die aktive Schicht angeordnet ist, im wesentlichen parallel zur Oberflächennormalen (200) der Oberfläche (20) des Substrats (2) ist.

3. Halbleiterlaser nach Anspruch 1 oder 2,
**dadurch gekennzeichnet,**
daß auf der von der Oberfläche (20) des Substrats (2) abgekehrten Seite der Schichtstruktur eine (14) der beiden Schichten (13, 14) aus Halbleitermaterial zueinander entgegengesetzten Leitfähigkeitstyps einen die aktive Schicht (15) und zumindest einen Teil der anderen Schicht (13) aus Halbleitermaterial überdeckenden Schichtabschnitt (144) aufweist, daß auf diesem überdeckenden Schichtabschnitt (144) der andere Resonatorspiegel (12) aufgebracht ist, und daß auf beiden Schichten (13, 14) aus Halbleitermaterial seitlich des anderen Resonatorspiegels (12) elektrische Kontakte (132, 142) vorgesehen sind.

4. Halbleiterlaser nach Anspruch 3, daß ein Resonatorspiegel (11, 12) in Form einer dielektrischen Vielfachschicht ausgebildet ist.

5. Verfahren zur Herstellung eines Halbleiterlasers nach einem der vorhergehenden Ansprüche,
**dadurch gekennzeichnet,**
- daß auf eine Oberfläche (20) eines Substrats (2) ein Resonatorspiegel (11) mit einer von der Oberfläche (20) des Substrats (2) abgekehrten und zu dieser Oberfläche (20) parallelen Oberfläche (111) aufgebracht wird,
- daß auf die Oberfläche (111) des Resonatorspiegels (11) eine abdeckende Maske (5) aus einem ein epitaktisches Wachstum hemmenden Material, die zumindest einen an einen geraden Rand (51, 52) der Maske (5) angrenzenden Bereich (115) der Oberfläche (111) des Resonatorspiegels (11) freiläßt, aufgebracht wird,
- daß epitaktisch mittels eines metallorganischen Abscheideverfahrens
- auf der mit dieser Maske (5) nicht abgedeckten Oberfläche (111) des Resonatorspiegels (11) eine Schicht (13) aus einem Halbleitermaterial eines Leitfähigkeitstyps und mit einer im Vergleich zu einem für die aktive Schicht (15) des Halbleiterlasers vorgesehenen Material größeren Bandlücke und kleineren Brechzahl aufgewachsen wird, wobei sich längs des genannten geraden Randes (51, 52) der Maske (5) ein mit der Oberflächennormalen (200) der Oberfläche (20) des Substrats (2) einen von 90° verschiedenen Winkel einschließender und die genannte eine Schichtebene (150), auf oder parallel zu der die aktive Schicht (15) anzuordnen ist, definierender ebener Oberflächenabschnitt (131) und eine zur Oberfläche (20) des Substrats (2) im wesentlichen paralleler Oberflächenabschnitt (132) ausbilden,
- auf dieser Schicht (13) aus dem Halbleitermaterial des einen Leitfähigkeitstyps die deren beiden Oberflächenabschnitte (131, 132) bedeckende aktive Schicht (15) aus einem Material mit einer im Vergleich zum Halbleitermaterial sowohl des einen Leitfähigkeitstyps kleineren Bandlücke und größeren Brechzahl aufgewachsen wird, und
- auf dieser aktiven Schicht (15) eine Schicht (14) aus einem Halbleitermaterial eines zum einen Leitfähigkeitstyp entgegengesetzten Leitfähigkeitstyps und mit einer im Vergleich zum Material der aktiven Schicht (15) größeren Bandlücke und kleineren Brechzahl aufgewachsen wird,
- daß die Schicht (14) aus dem Halbleitermaterial des entgegengesetzten Leitfähigkeitstyps und die aktive Schicht (15) durch ein Abtragverfahren so weit reduziert werden, daß nur Schichtabschnitte (151, 141) dieser beiden Schichten (15, 14) stehenbleiben, die auf dem die Schichtebene (150) definierenden ebenen Oberflächenabschnitt (131) der Schicht (13) aus dem Halbleitermaterial des einen Leitfähigkeitstyps aufgewachsen sind,
- daß die Maske (5) entfernt wird,
- daß die Oberfläche (111) des Resonatorspiegels (11) und die darauf stehengebliebenen Teile der aktiven Schicht (15) und der zwei Schichten (13, 14) aus Halbleitermaterial zueinander entgegengesetzten Leitfähigkeitstyps vollständig mit einer weiteren Schicht (140) aus einem Halbleitermaterial des zum einen Leitfähigkeitstyp entgegengesetzten Leitfähigkeitstyps überwachsen werden, und
- daß auf eine von der Oberfläche (20) des Substrats (2) abgekehrte Oberfläche (145) dieser weiteren Schicht (140) ein anderer Resonatorspiegel (12) aufgebracht wird.

6. Verfahren nach Anspruch 6 zur Herstellung eines Halbleiterlasers nach Anspruch 4 oder 5,
**dadurch gekennzeichnet,**
daß der andere Resonatorspiegel (12) teilweise abgetragen wird, so daß auf einer Seite der Schichtebene (150), in der die verbliebene aktive Schicht (15) angeordnet ist, ein Bereich der weiteren Schicht (140), und auf der anderen Seite dieser Schichtebene (150) ein Bereich der Schicht (13) aus Halbleitermaterial des einen Leitfähigkeitstyps freigelegt werden, und daß auf die freigelegten Bereiche dieser Schichten (140, 13) elektrische Kontakte (132, 142) aufgebracht werden.

7. Verfahren zur Herstellung eines Halbleiterlasers mit einer auf einer Oberfläche (40) eines Substrats (4) zwischen zwei Resonatorspiegeln angeordneten Schichtstruktur, bei der zwischen einer Schicht (33) aus einem Halbleitermaterial eines Leitfähigkeitstyps und einer Schicht (34) aus einem Halbleitermaterial eines zum einen Leitfähigkeitstyp entgegengesetzten Leitfähigkeitstyps eine an die beiden Schichten (33, 34) aus Halbleitermaterial angrenzende aktive Schicht (35) angeordnet ist,
- wobei die aktive Schicht (35) aus einem Material mit einer im Vergleich zum Halbleitermaterial sowohl des einen als auch des entgegengesetzten Leitfähigkeitstyps kleineren Bandlücke und größeren Brechzahl besteht,
- die Resonatorspiegel jeweils in einer mit der Oberfläche (40) des Substrats (4) einen von 0° verschiedenen Winkel einschließenden Spiegelebene angeordnet sind,
- die aktive Schicht (35) wenigstens einen Schichtabschnitt aufweist, der auf oder parallel zu einer vorbestimmten, mit der Oberflächennormalen (400) der Oberfläche (40) des Substrats (4) einen von 90° verschiedenen Winkel einschließenden Schichtebene (350) angeordnet ist, und
- die Schichtebene (350) mit der Spiegelebene jedes Resonatorspiegels einen von 0° verschiedenen Winkel einschließt,
**dadurch gekennzeichnet,**
daß auf die Oberfläche (40) des Substrats (4) eine abdeckende Maske aus einem ein epitaktisches Wachstum hemmenden Material, die zumindest einen an einen geraden Rand der Maske angrenzenden Bereich der Oberfläche (40) des Substrats (4) freiläßt, aufgebracht wird,
- daß epitaktisch mittels eines metallorganischen Abscheideverfahrens
- auf der mit dieser Maske nicht abgedeckten Oberfläche (40) des Substrats (4) die Schicht (33) aus dem Halbleitermaterial des einen Leitfähigkeitstyps aufgewachsen wird, wobei sich längs des genannten geraden Randes der Maske ein mit der Oberflächennormalen (400) der Oberfläche (40) des Substrats (4) einen von 90° verschiedenen Winkel einschließender und die Schichtebene (350) definierender Oberflächenabschnitt und ein zur Oberfläche (40) des Substrats (4) paralleler Oberflächenabschnitt der Schicht (33) aus dem Halbleitermaterial des einen Leitfähigkeitstyps ausbilden,
- auf dieser Schicht (33) aus dem Halbleitermaterial des einen Leitfähigkeitstyps die deren beiden Oberflächenabschnitte bedeckende aktive Schicht (35) aus dem für diese aktive Schicht (35) vorgesehenen Material aufgewachsen wird, und
- auf dieser aktiven Schicht (35) die Schicht (34) aus einem Halbleitermaterial des zum einen Leitfähigkeitstyp entgegengesetzten Leitfähigkeitstyps aufgewachsen wird,
- daß die Schicht (34) aus dem Halbleitermaterial des entgegengesetzten Leitfähigkeitstyps und die aktive Schicht (35) durch ein Abtragverfahren so weit reduziert werden, daß nur Schichtabschnitte dieser beiden Schichten (35, 34) stehenbleiben, die auf dem die Schichtebene (350) definierenden ebenen Oberflächenabschnitt der Schicht (33) aus dem Halbleitermaterial des einen Leitfähigkeitstyps aufgewachsen sind,
- daß die Maske (5) entfernt wird, und
- daß die von der Maske befreite Oberfläche (40) des Substrats (4) und die darauf stehengebliebenen Teile der aktiven Schicht (35) und der zwei Schichten (33, 34) aus Halbleitermaterial zueinander entgegengesetzten Leitfähigkeitstyps vollständig mit einer weiteren Schicht aus dem Halbleitermaterial des zum einen Leitfähigkeitstyp entgegengesetzten Leitfähigkeitstyps überwachsen werden.

8. Verfahren nach Anspruch 7,
**dadurch gekennzeichnet,**
daß auf einer Seite der Schichtebene (350) auf einen Bereich der weiteren Schicht und auf der anderen Seite dieser Schichtebene (350) auf einen Bereich der Schicht (33) aus dem Halbleitermaterial des einen Leitfähigkeitstyps jeweils ein elektrischer Kontakt (342, 332) aufgebracht wird.

## Claims

1. Semiconductor laser (1) having a layered structure which is arranged on a surface (20) of a substrate (2) between two resonator mirrors (11, 12) and in which there is arranged on or parallel to a layer surface (150) between a layer (13) made from a semiconductor material of one conductivity type and a layer (14) made from a semiconductor material of a conductivity type opposite to the one conductivity type an active layer (15) adjoining the two layers (13, 14) made from semiconductor material,
- the active layer (15) comprising a material having a smaller band gap and larger refractive index by comparison with the semiconductor material both of the one and of the opposite conductivity type,
- the resonator mirrors (11, 12) being arranged parallel to the surface (20) of a substrate (2),
a resonator mirror (11) being arranged on the surface (20) of the substrate (2),
the layer (13) made from semiconductor material of one conductivity type, the active layer (15) and the layer (14) made from semiconductor material of the conductivity type opposite to the one conductivity type being arranged next to one another on the surface (111), averted from the surface (20) of the substrate (2), of the resonator mirror (11) arranged on the surface (20) of the substrate (2), characterized in that the layer surface (150) on or parallel to which the active layer (15) is arranged is a layer plane,
in that this layer surface (150) encloses with the surface normal (200) of the surface (20) of the substrate (2) an angle differing from 90°.

2. Semiconductor laser according to Claim 1, characterized in that the layer plane (150) on or parallel to which the active layer is arranged is essentially parallel to the surface normal (200) of the surface (20) of the substrate (2).

3. Semiconductor laser according to Claim 1 or 2, characterized in that on the side of the layer structure averted from the surface (20) of the substrate (2) one (14) of the two layers (13, 14) made from semiconductor material of mutually opposite conductivity type has a layer section (144) covering the active layer (15) and at least a part of the other layer (13) made from semiconductor material, in that the other resonator mirror (12) is applied to this covering layer section (144), and in that electric contacts (132, 142) are provided on both layers (13, 14) made from semiconductor material to the side of the other resonator mirror (12).

4. Semiconductor laser according to Claim 3, characterized in that one resonator mirror (11, 12) is constructed in the form of a dielectric multilayer.

5. Method for producing a semiconductor laser according to one of the preceding claims, characterized in that
- a resonator mirror (11) having a surface (111) averted from the surface (20) of the substrate (2) and parallel to this surface (20) is applied to a surface (20) of a substrate (2),
- in that a covering mask (5) which is made from a material inhibiting epitactical growth and exposes at least one region (115), adjoining a straight edge (51, 52) of the mask (5), of the surface (111) of the resonator mirror (11) is applied to the surface (111) of the resonator mirror (11),
- in that in an epitactical fashion by means of an organometallic deposition method
- there is grown on the surface (111) of the resonator mirror (11) not covered by this mask (5) a layer (13) made from a semiconductor material of one conductivity type and having a larger band gap and smaller refractive index by comparison with a material provided for the active layer (15) of the semiconductor laser, it being the case that there are formed along the said straight edge (51, 52) of the mask (5) a plane surface section (131), which encloses with the surface normal (200) of the surface (20) of the substrate (2) an angle differing from 90° and defines the said one layer plane (150) on or parallel to which the active layer (15) is to be arranged and a surface section (132) essentially parallel to the surface (20) of the substrate (2),
- there is grown on this layer (13), made from the semiconductor material of one conductivity type, the active layer (15), covering both its surface sections (131, 132) and made from a material having a smaller band gap and larger refractive index by comparison with the semiconductor material of one conductivity type, and
- there is grown on this active layer (15) a layer (14) made from a semiconductor material of a conductivity type opposite to the one conductivity type and having a larger band gap and smaller refractive index by comparison with the material of the active layer (15),
- in that the layer (14) made from the semiconductor material of the opposite conductivity type and the active layer (15) are reduced to such an extent by a removal method that only layer sections (151, 141) of these two layers (15, 14) remain which are grown on the plane surface section (131), defining the layer plane (150), of the layer (13) made from the semiconductor material of the one conductivity type,
- in that the mask (5) is removed,
- in that the surface (111) of the resonator mirror (11) and the parts, remaining thereon, of the active layer (15) and of the two layers (13, 14) made from semiconductor material of mutually opposite conductivity type are completely overgrown by a further layer (140) made from a semiconductor material of the conductivity type opposite to the one conductivity type, and
- in that another resonator mirror (12) is applied to a surface (145) averted from the surface (20) of the substrate (2), of this further layer (140).

6. Method according to Claim 6 for producing a semiconductor laser according to Claim 4 or 5, characterized in that the other resonator mirror (12) is partially removed so that on a side of the layer plane (150) in which the remaining active layer (15) is arranged a region of the further layer (140) is exposed, and on the other side of this layer plane (150) a region of the layer (13) made from semiconductor material of the one conductivity type is exposed, and in that electric contacts (132, 142) are applied to the exposed regions of these layers (140, 13).

7. Method for producing a semiconductor laser having a layered structure which is arranged on a surface (40) of a substrate (4) between two resonator mirrors and in which there is arranged between a layer (33) made from a semiconductor material of one conductivity type and a layer (34) made from a semiconductor material of a conductivity type opposite to the one conductivity type an active layer (35) adjoining the two layers (33, 34) made from semiconductor material,
- the active layer (35) comprising a material having a smaller band gap and larger refractive index by comparison with the semiconductor material both of the one and of the opposite conductivity type,
- the resonator mirrors being respectively arranged in a mirror plane enclosing with the surface (40) of the substrate (4) an angle differing from 0°,
- the active layer (35) having at least one layer section which is arranged on or parallel to a predetermined layer plane (350) enclosing with the surface normal (400) of the surface (40) of the substrate (4) an angle differing from 90°, and
- the layer plane (350) enclosing with the mirror plane of each resonator mirror an angle differing from 0°,
characterized in that there is applied to the surface (40) of the substrate (4) a covering mask which is made from a material inhibiting epitactical growth and exposes at least one region, adjoining a straight edge of the mask, of the surface (40) of the substrate (4),
- in that in an epitactical fashion by means of an organometallic deposition method
- there is grown on the surface (40), not covered by this mask, of the substrate (4) the layer (33) made from the semiconductor material of the one conductivity type, it being the case that there are formed along the said straight edge of the mask a surface section, which encloses with the surface normal (400) of the surface (40) of the substrate (4) an angle differing from 90° and defines the layer plane (350) and a surface section parallel to the surface (40) of the substrate (4) of the layer (33) made from the semiconductor material of the one conductivity type,
- there is grown on this layer (33) made from the semiconductor material of the one conductivity type the active layer (35), covering its two surface sections, made from the material provided for this active layer (35), and
- there is grown on this active layer (35) the layer (34) made from a semiconductor material of the conductivity type opposite to the one conductivity type,
- in that the layer (34) made from the semiconductor material of the opposite conductivity type and the active layer (35) are reduced to such an extent by a removal method that only layer sections of these two layers (35, 34) remain which are grown on the plane surface section, defining the layer plane (350), of the layer (33) made from the semiconductor material of the one conductivity type,
- in that the mask (5) is removed,
- in that the surface (40) of the substrate (4), which surface (40) is freed from the mask, and the parts, remaining thereon, of the active layer (35) and of the two layers (33, 34) made from semiconductor material of mutually opposite conductivity type are completely overgrown by a further layer made from the semiconductor material of the conductivity type opposite to the one conductivity type.

8. Method according to Claim 7, characterized in that an electric contact (342, 332) is respectively applied on one side of the layer plane (350) to a region of the further layer and on the other side of this layer plane (350) to a region of the layer (33) made from the semiconductor material of the one conductivity type.

## Revendications

1. Laser à semi-conducteur (1) comprenant une structure stratifiée disposée sur une surface (20) d'un substrat (2) entre deux miroirs de résonateur (11, 12) et dans laquelle il est prévu, sur une surface de couche (150), ou parallèlement à cette surface, entre une couche (13) faite d'un matériau semi-conducteur d'un premier type de conductivité et une couche (14) faite d'un matériau semi-conducteur d'un type de conductivité opposé au premier type de conductivité, une couche active (15) qui est adjacente aux deux couches (13, 14) de matériau semi-conducteur,
- la couche active (15) étant composée d'un matériau qui possède une plus petite bande interdite et un plus grand indice de réfraction que le matériau semi-conducteur, tant d'un type de conductivité que du type de conductivité opposé,
- les miroirs de résonateur (11, 12) sont disposés parallèlement à la surface (20) du substrat (2),
un miroir de résonateur (11) étant disposé sur la surface (20) du substrat (2),
la couche (13) en matériau semi-conducteur d'un premier type de conductivité, la couche active (15) et la couche (14) faite d'un matériau semi-conducteur du type de conductivité opposé au premier type de conductivité étant disposées l'une à côté de l'autre sur la surface (111), éloignée de la surface (20) du substrat (2), du miroir de résonateur (11) disposé sur la surface (20) du substrat (2).
caractérisé en ce que la surface de couche (150) sur laquelle ou parallèlement à laquelle la couche active (15) est disposée, est un plan de couche et
en ce que cette surface de couche (150) forme un angle différent de 90° avec la normale (200) à la surface (20) du substrat (1).

2. Laser à semi-conducteur selon la revendication 1,
caractérisé en ce que
le plan de couche (150) sur lequel ou parallèlement auquel la couche active est disposée est sensiblement parallèle à la normale (200) à la surface (20) du substrat (2).

3. Laser à semi-conducteur selon la revendication 1 ou 2,
caractérisé en ce que
sur la face de la structure stratifiée qui est éloignée de la surface (20) du substrat (2), l'une (14) des deux couches (13, 14) de matériaux semi-conducteurs de types de conductivité mutuellement opposés présente un segment de couche (144) qui recouvre la couche active (15) et au moins une partie de l'autre couche (13) en matériau semi-conducteur,
en ce que l'autre miroir de résonateur (12) est déposé sur ce segment de couche recouvrant (144) et en ce que, sur les deux couches (13, 14) en matériau semi-conducteur, sont prévus des contacts électriques (132, 142) disposés latéralement à l'autre miroir de résonateur (12).

4. Laser à semi-conducteur selon la revendication 3, caractérisé en ce qu'un miroir de résonateur (11, 12) est réalisé sous la forme d'une couche multiple diélectrique.

5. Procédé de fabrication d'un laser à semi-conducteur selon l'une des revendications précédentes,
caractérisé
- en ce que, sur une surface (20) d'un substrat (2), on dépose un miroir de résonateur (11) possédant une surface (111) qui est à l'opposé de la surface (20) du substrat (2) et est parallèle à cette surface (20),
- en ce que, sur la surface (111) du miroir de résonateur (11), on dépose un masque recouvrant (5) fait d'un matériau qui inhibe la croissance épitaxiale qui dégage au moins une région (115) de la surface (111) du miroir de résonateur (11) qui se termine contre un bord droit (51, 52) du masque (5),
- en ce que, par voie épitaxique, au moyen d'un procédé de dépôt organométallique,
- on dépose sur la surface (111) du miroir de résonateur (11) qui n'est pas recouverte par ce masque (5), une couche (13) faite d'un matériau semi-conducteur ayant un premier type de conductivité et qui possède une plus grande bande interdite et un plus petit indice de réfraction qu'un matériau prévu pour la couche active (15) du laser à semi-conducteur, un segment de surface plan (131) qui forme un angle différent de 90° avec la normale (200) à la surface (20) du substrat (2) et qui définit ledit premier plan de couche (150) sur lequel ou parallèlement auquel doit être disposée la couche active (15) et un segment de surface (132) sensiblement parallèle à la surface (20) du substrat (2) se formant le long dudit bord rectiligne (51, 52) du masque (5).
- sur cette couche (13) faite du matériau semi-conducteur d'un premier type de conductivité, on dépose la couche active (15) qui recouvre les deux segments de surface (131, 132) de cette couche, et qui est faite d'un matériau ayant une plus petite bande interdite et un plus grand indice de réfraction que le matériau semi-conducteur du premier type de conductivité, et
- sur cette couche active (15) on dépose une couche (14) faite d'un matériau semi-conducteur d'un type de conductivité opposé au premier type de conductivité, et possédant une plus grande bande interdite et un plus petit indice de réfraction que le matériau de la couche active (15),
- en ce que la couche (14) faite du matériau semi-conducteur du type de conductivité opposé et la couche active (15) sont suffisamment réduites par un procédé d'ablation pour que seuls subsistent des segments (141, 151) de ces deux couches (15, 14) qu'on a déposés sur le segment de surface plan (131), de la couche (13) faite du matériau semi-conducteur du premier type de conductivité et qui définit le plan de couche (150).
- en ce qu'on enlève le masque (5),
- en ce qu'on recouvre entièrement la surface (111) du miroir de résonateur (11) et les parties de la couche active (15) et des deux couches (13, 14) faites de matériaux semi-conducteurs ayant des types de conductivité mutuellement opposés, qui subsistent sur cette surface, avec une autre couche (140) faite d'un matériau semi-conducteur du type de conductivité opposé au premier type de conductivité, et
- en ce qu'on dépose un autre miroir de résonateur (12) sur une surface (145) de cette autre couche (140) qui est éloignée de la surface (20) du substrat (2).

6. Procédé selon la revendication 6, pour la fabrication d'un laser à semi-conducteur selon la revendication 4 ou 5,
caractérisé
en ce qu'on enlève partiellement l'autre miroir de résonateur (12), de sorte que, sur un côté du plan de couche (150) dans lequel la couche active (15) restante est disposée, on dégage une région de l'autre couche (140) et, sur l'autre côté de ce plan de couche (150), on dégage une région de la couche (13) en matériau semi-conducteur du premier type de conductivité, et en ce que, sur les régions dégagées de ces couches (140, 13), on dépose des contacts électriques (132, 142).

7. Procédé de fabrication d'un laser à semi-conducteur comprenant une structure stratifiée disposée sur une surface (40) d'un substrat (4) entre deux miroirs de résonateur, et dans laquelle est disposée, entre une couche (33) d'un matériau semi-conducteur d'un premier type de conductivité et une couche (34) d'un matériau semi-conducteur d'un type de conductivité opposé au premier type de conductivité, une couche active (35) adjacente aux deux couches (33, 34) en matériau semi-conducteur,
- la couche active (35) étant faite d'un matériau ayant une plus petite bande interdite et un plus grand indice de réfraction que les matériaux semi-conducteurs tant du premier type de conductivité que du type de conductivité opposé,
- les miroirs de résonateur sont disposés chacun dans un plan de miroir qui forme un angle différent de 0° avec la surface (40) du substrat (4),
- la couche active (35) présente au moins un segment de couches qui est disposé sur, ou parallèlement à, un plan de couche (350) prédéterminé, qui forme un angle différent de 90° avec la normale (400) à la surface (40) du substrat (4), et
- le plan de couche (350) forme un angle différent de 0° avec le plan de miroir de chaque miroir de résonateur,
caractérisé
en ce que, sur la surface (40) du substrat (4), on dépose un masque recouvrant fait d'un matériau inhibant la croissance épitaxiale, qui dégage au moins une région de la surface (40) du substrat (4) qui est adjacente à un bord rectiligne du masque,
- en ce que, par voie épitaxiale, par un procédé de dépôt organométallique,
- on dépose sur la surface (40) du substrat (4) qui n'est pas recouverte par ce masque, la couche (33) faite du matériau semi-conducteur du premier type de conductivité, un segment de surface formant un angle différent de 90° avec la normale (400) à la surface (40) du substrat (4), et qui définit le plan de couche (350), et un segment de surface de la couche (33) en matériau semi-conducteur du premier type de conductivité, qui est parallèle à la surface (40) du substrat (4) se formant le long dudit bord rectiligne du masque.
- en ce que, sur cette couche (33) faite du matériau semi-conducteur du premier type de conductivité, on dépose la couche active (35) faite du matériau prévu pour cette couche active (35) et qui recouvre les deux segments de surface de cette couche (33), et
- en ce que, sur cette couche active (35), on dépose la couche (34) faite d'un matériau semi-conducteur du type de conductivité opposé au premier type de conductivité,
- en ce que la couche (34) faite du matériau semi-conducteur du type de conductivité opposé et la couche active (35) sont suffisamment réduites par un procédé d'ablation pour que seuls subsistent des segments de ces deux couches (35, 34) qu'on a déposés sur le segment de surface plan de la couche (33) faite du matériau semi-conducteur du premier type de conductivité qui définit le plan de couche (350)
- en ce qu'on enlève le masque (5), et
- en ce qu'on recouvre entièrement la surface (40) du substrat (4) qui est dégagée par le masque et les parties de la couche active (35) et des deux couches (33, 34) faites de matériaux semi-conducteurs ayant des types de conductivité mutuellement opposés qui subsistent sur cette surface, avec une autre couche faite du matériau semi-conducteur du type de conductivité opposé au premier type de conductivité.

8. Procédé selon la revendication 7,
caractérisé
en ce que, sur un côté du plan de couche (350), on dépose un contact électrique (342, 332) sur une région de l'autre couche et, sur l'autre côté de ce plan de couche, on dépose un contact électrique (342, 332) sur une région de la couche (33) qui est faite du matériau semi-conducteur du premier type de conductivité.
